(19)

Europäisches
Patentamt
European
Patent Office
Office européen
des brevets

(11) **EP 4 564 018 A1**

(12) **EUROPEAN PATENT APPLICATION**

(43) Date of publication:
**04.06.2025 Bulletin 2025/23**

(21) Application number: **23212946.0**

(22) Date of filing: **29.11.2023**

(51) International Patent Classification (IPC):
*G01R 21/133* [(2006.01)]    *G01R 22/10* [(2006.01)]
*G01R 23/02* [(2006.01)]

(52) Cooperative Patent Classification (CPC):
**G01R 23/02; G01R 21/133; G01R 22/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Kamstrup A/S
8660 Skanderborg (DK)**

(72) Inventors:
- **Kirkegaard, Dennis
8660 Skanderborg (DK)**
- **Jørgensen, Jesper
8660 Skanderborg (DK)**
- **Kjeldmand, Rasmus Melbye
8660 Skanderborg (DK)**

(74) Representative: **Patentanwälte Hemmer Lindfeld
Frese
Partnerschaft mbB
Wallstraße 33a
23560 Lübeck (DE)**

(54) **METHOD FOR ESTIMATING A GRID FREQUENCY BY AN ELECTRICITY CONSUMPTION METER IN AN ELECTRICAL GRID**

(57)    The present invention refers to an electricity meter (7) for determining electricity consumption in a an electrical grid (1), wherein the electricity meter (7) comprises:
- an analogue-to-digital converter (15) for providing raw samples of a voltage and/or a current at a phase (a, b, c) of the electrical grid (1), wherein the voltage and/or the current has a potentially varying grid frequency,
- at least one microcontroller (13) for calculating electricity consumption from the electrical grid (1), and
- a grid frequency estimation algorithm for being executed by the at least one microcontroller (13),

characterised in that
the grid frequency estimation algorithm is configured to provide input samples based on the raw samples at an adaptable input sampling rate, wherein the input sampling rate is a whole-numbered multiple of an inversed period length of a preceding period of the grid frequency and adapted by using a feedback signal (ISI) being fed back in a closed-loop control, wherein the grid frequency estimation algorithm is configured to estimate the grid frequency based on a phase shift ($\Delta\varphi$) indicated by the resamples within the period length of said preceding period of the grid frequency.

Fig. 2

EP 4 564 018 A1

**Description**

TECHNICAL FIELD

The present invention is directed to the field of using electricity meters, predominantly used to determine electricity consumption in an electrical grid for billing purposes, in addition for estimating a potentially varying grid frequency of the electrical grid.

BACKGROUND

Knowing the frequency of an electrical grid is very important for many electricity grid applications. Firstly, the frequency must be kept stable within a narrow range around the nominal frequency of, e. g., 50Hz or 60Hz. So far, the responsibility for that has rested with the operators of large thermal power plants. But that is changing as more and more distributed energy resources are integrated into the electrical grid during in the transition process from fossil-based energy sources to renewable energies. Secondly, a fast and precise knowledge of the current frequency enables numerous features for smart grid applications, including additional features in smart meters. Among those could be frequency-dependent activations of relays, calculation of individual harmonic components in the current and voltage waveforms, calculation of rate of change of frequency for stability monitoring, frequency-dependent tariffs and billing, validation of delivered ancillary services like frequency containment reserve (FCR) and fast frequency response (FFR), etc. All of these become more important the more renewable energy sources feed energy into the electrical grid instead of traditional thermal power plants. Operators of electrical grids therefore have a high interest in having very quick, robust and reliable information about the current grid frequency of the electric grid.

It is known that electricity meters, predominantly used to determine electricity consumption in an electrical grid for billing purposes, may be used to compensate a potentially varying grid frequency. For example, US 2023/0143318 A1 describes a method of processing power signals using a fundamental frequency detector based on zero-crossings. US 2023/0143318 A1 transforms a resampled digital power signal to a frequency-domain by a first Fast-Fourier-Transformation (FFT) and transforms the resampled digital power signal, after being adjusted according to a calculated phase angle, again to an updated frequency-domain by a second Fast-Fourier-Transformation (FFT).

US 7,444,249 A describes a system that determines if a fundamental frequency that is measured using zero-crossings lies within a preselected range or not. If it lies outside that range, the signal is resampled at a resampling rate that is coherent with the measured fundamental frequency.

The systems known from the prior art using zero-crossings for determining the frequency have the disadvantage that a sufficient number of zero-crossings, e. g. 100 or more, must be considered before a frequency can be reliably determined. So, the known systems have a latency of at least one second or more. If the number of considered zero-crossings is reduced, the accuracy of the frequency determination is impaired.

It is therefore a problem of the present invention to more quickly and reliably estimate a potentially varying grid frequency of an electrical grid without using zero-crossings by means of an electricity meter that is predominantly used to determine electricity consumption in an electrical grid for billing purposes.

SUMMARY

The electricity meter, the method and the computer program according to the independent claims provide a solution to this problem. Preferred embodiments are given in the dependent claims, the description and/or figures.

According to a first aspect of the present invention, an electricity meter for determining electricity consumption in an electrical grid is provided, wherein the electricity meter comprises:

- an analogue-to-digital converter for providing raw samples of a voltage and/or a current at a phase of the electrical grid, wherein the voltage and/or the current has a potentially varying grid frequency,
- at least one microcontroller for calculating electricity consumption from the electrical grid, and
- a grid frequency estimation algorithm for being executed by the at least one microcontroller,

characterised in that
the grid frequency estimation algorithm is configured to provide input samples based on the raw samples at an adaptable input sampling rate, wherein the input sampling rate is a whole-numbered multiple of an inversed period length of a preceding period of the grid frequency and adapted by using a feedback signal being fed back in a closed-loop control, wherein the grid frequency estimation algorithm is configured to estimate the grid frequency based on a phase shift indicated by the input samples within the period length of said preceding period of the grid frequency.

The inventive algorithm allows for an estimation of the grid frequency with an accuracy of $\pm 1.0$mHz or less. The

inventive grid frequency estimation algorithm is extremely quick (up to only 1-2 periods latency, i. e. 20-40 ms). However, in practice, said preceding period of the grid frequency may be one of the latest preceding 5-10 periods of the grid frequency, or an average thereof. This is sufficiently quick to achieve a latency of less than 0.2 seconds for continuously having a reliable estimation of the current grid frequency, which is still at least a factor 5 faster than known systems based on zero-crossings. It should be noted that the inventive grid frequency estimation algorithm may be fully implemented as a software update of the firmware of the electricity meter without any changes to the hardware.

Optionally, the grid frequency estimation algorithm may be configured to adapt the input sampling rate by interpolating between the raw samples and/or by adapting a raw sampling rate at which the analogue-to-digital converter provides the raw samples. The first option of interpolating between the raw samples is effectively a resampling at an adaptable resampling rate. Interpolating may be advantageous, because it can be implemented as a software update of the firmware of the electricity meter. The analogue-to-digital converter usually has a fixed raw sampling rate. The second option of adapting the input sampling rate by adapting the raw sampling rate may thus require that the electricity meter is equipped with an analogue-to-digital converter providing an adaptable raw sampling rate with a sufficiently high granularity. In the second option, the adaptable input sample rate may be the adaptable raw sampling rate or a whole-numbered fraction thereof.

For example, the interpolation between the raw samples may be implemented as a resampling or down-sampling with the input samples being the interpolated output as follows. The input sampling rate is to be an exact whole-numbered, preferably a radix-2, multiple of the fundamental grid frequency, e. g. exactly 512 times the inversed period length of a preceding period of the grid frequency. In case of 50.00 Hz grid frequency, the input sampling rate would be 25.6 kHz, which corresponds to an input sampling period of 39.0625 μs. The input sampling rate $f_{res}$ could also be expressed with respect to the fixed raw sampling rate $f_s$ , e. g. $f_s$ = 56.2432 $kHz$ as an input sample interval (ISI)

$$\text{ISI} = \frac{f_s}{f_{res}} .$$

In case of 50.00 Hz grid frequency, ISI would then be 2.197 raw samples per input sample. ISI expresses the distance in number of raw samples between two consecutive input sample points. Without filtering, the interpolated output would be a weighted sum of two consecutive raw samples: $s_{out}[k] = q_0[k] \cdot s_{in}[n + 1] + (1 - q_0[k]) \cdot s_{in}[n]$, where the weight $q_0[k] \in [0:1]$ is the fractional part of the input sample point (ISP), wherein $s_{out}[k]$ is calculated with

$$\text{ISP}[k] = \text{ISP}[k - 1] + \text{ISI}$$

$$n = \text{floor}(\text{ISP}[k])$$

$$q_o[k] = \text{ISP}[k] - n$$

wherein k is an input sample index. Before the interpolation is calculated, it may be beneficial to suppress the worst high-frequency noise with a simple FIR filter with even weighted coefficients. If the scale is ignored until a later process, this could be written as

$$s_{in}[n] = s_{raw}[n] + s_{raw}[n - 1]$$

Substituting this into the expression for $s_{out}$ and time shift $n$ to make the process causal, gives:

$$s_{out}[k] = q_0[k] \cdot (s_{raw}[n] + s_{raw}[n - 1]) + (1 - q_0[k])$$
$$\cdot (s_{raw}[n - 1] + s_{raw}[n - 2])$$
$$= q_0[k] \cdot s_{raw}[n] + q_0[k] \cdot s_{raw}[n - 1] + (1 - q_0[k]) \cdot s_{raw}[n - 1]$$
$$+ (1 - q_0[k]) \cdot s_{raw}[n - 2]$$

$$\Updownarrow$$

$$s_{out}[k] = q_0[k] \cdot s_{raw}[n] + s_{raw}[n - 1] + (1 - q_0[k]) \cdot s_{raw}[n - 2]$$

The data $s_{out}$ from this interpolation process may be buffered in a subset of 128 input samples at a time in a ping-pong buffer, wherein one part of the ping-pong buffer is filled by this interpolation process while the other part is being processed by a subsequent filtering process.

The duration or time span for the subset of the 128 input samples of $s_{out}$ is

$$128 \cdot \frac{ISI}{f_s} = \frac{128 \cdot ISI}{56.2432\,\text{kHz}} \, .$$

During nominal conditions of 50.00Hz grid frequency, the duration of one full buffer of a subset of 128 input samples is then exactly 5.00ms or 281.2160 raw samples. However, if the grid frequency changes, the ISI is adapted to adapt the input sampling rate. The duration of one full buffer of input samples, which depends on the ISI, is preferably forwarded to the subsequent filtering process to keep track of the period length.

The ISI could be used as the feedback signal that is fed back in the closed-loop control from a preceding period of the grid frequency. The ISI may be updated using the formula:

$$ISI = \frac{f_s}{N \cdot f} \, ,$$

wherein $N = 128 \cdot 2 \cdot 2 = 512$ and $f_s$ is the raw sampling rate given by the analogue-to-digital converter. The grid frequency f may be estimated based on the phase shift $\Delta\varphi$ of a preceding period by

$$f = \frac{2\pi + \Delta\varphi}{\Delta t \cdot 2\pi} \, ,$$

wherein $\Delta t$ is a duration or time span of said preceding period.

Optionally, the grid frequency estimation algorithm may be configured to provide the input samples within one period of the grid frequency. This allows providing an estimation of the current grid frequency for each period. If such a high resolution of frequency estimates over time is not needed, the input samples may span across more than one period of the current grid frequency.

Optionally, the input sampling rate may be a radix-2 multiple of the inversed period length of said preceding period of the grid frequency. This is beneficial to avoid spectral leakage if a Fast-Fourier-Transformation (FFT) is used to provide fundamental components, e.g. the second and complex bins of the FFT, describing the amplitude and phase angle of the fundamental grid frequency.

Optionally, the grid frequency estimation algorithm may be configured to continuously or periodically re-estimate the grid frequency each whole-numbered and/or half-numbered multiple of the period of the grid frequency based on the input samples, wherein the re-estimated grid frequency is provided to other applications for being executed by the at least one microcontroller and is used to provide the feedback signal for the following grid frequency estimation for a subsequent period of the grid frequency. This is particularly beneficial to provide an estimation of the grid frequency with a high resolution in time.

Optionally, the grid frequency estimation algorithm may be configured to apply one or more filter stages for reducing noise from the input samples before the grid frequency is estimated on a filtered subset of input samples that spans exactly across the period length of said preceding period of the grid frequency. For example, only frequencies around the Nyquist frequency may be considered for the filter attenuation, because frequencies outside of 50 fundamental harmonics of the Nyquist frequency do not interfere with a legal band of interest. The one or more filters may be implemented as finite impulse response (FIR) filters, infinite impulse response (IIR) filters, and/or hardware filters.

Optionally, the grid frequency estimation algorithm may be configured to apply a Fast-Fourier-Transformation (FFT) on the, preferably filtered, input samples for determining the phase shift. Preferably, the input sampling rate is a radix-2 multiple of the inversed period length of said preceding period of the grid frequency in order to avoid spectral leakage when using an FFT.

Optionally, the grid frequency estimation algorithm may be configured to increase the input sampling rate if the phase shift is positive and to decrease the input sampling rate if the phase shift is negative. The estimated grid frequency thus scales with the phase shift.

Optionally, the grid frequency estimation algorithm may be configured to determine the feedback signal based on the phase shift and an adjusted period length, wherein the period length is adjusted based on a known group delay induced by any one or more filter stages applied before the grid frequency is estimated.

For example, the grid frequency may be estimated as f by using the formula

$$f = \frac{2\pi + \Delta\varphi}{\Delta t \cdot 2\pi} \quad ,$$

wherein $\Delta\varphi$ is the phase shift and $\Delta t$ is the period length. The phase shift $\Delta\varphi$ may be calculated for the n-th grid frequency period as

$$\Delta\varphi[n] = \arg\big(V_{basis}[n] \cdot \mathrm{conj}(V_{basis}[n-1])\big),$$

e.g.

$$\Delta\varphi[n] = \mathrm{atan2}\big(Im(V_{basis}[n] \cdot \mathrm{conj}(V_{basis}[n-1])), Re(V_{basis}[n] \cdot \mathrm{conj}(V_{basis}[n-1]))\big)$$

wherein $V_{basis}[n]$ is, for instance, a symmetrical voltage component of the fundamental phase components that are connected to the terminals of the electricity meter. The period length $\Delta t$ may be calculated as a weighted sum of the two latest periods

$$\Delta t[n] = (0.5 - \delta) \cdot t_{period}[n] + (0.5 + \delta) \cdot t_{period}[n-1] \quad ,$$

wherein $t_{period}[n]$ is the time length of the n-th grid frequency period and $\delta$ is a known group delay induced by the one or more filter stages. The group delay $\delta_x$ induced by filter x, normalized to grid-fundamental periods $f_n$, may be

$$\delta_x = \frac{M_x \cdot f_n}{2 f_{s_{in_x}}} \quad ,$$

where $M_x$ is the number of filter bins of filter x and $f_{s_{in_x}}$ is the input data rate of the filter x. In case of two filters, the group delay may be $\delta_1 = \frac{M_1}{2 \cdot 512}$ for the first filter and $\delta_2 = \frac{M_2}{2 \cdot 256}$ for the second filter, and the total group delay induced by the two filter stages may be $\delta = \delta_1 + \delta_2$. It should be noted that the interpolation does not add significantly to the time duration $\Delta t$.

Optionally, the grid frequency estimation algorithm may be configured to interpolate one period of the grid frequency in binary fractions of a period at a time and to consecutively buffer the input samples in corresponding binary fractions, wherein the grid frequency estimation algorithm is further configured to apply one or more filter stages for reducing noise from the buffered binary fractions of the input samples, wherein each of the one or more filter stages reduces the input sampling rate by half and doubles the number of buffered binary fractions of the input samples that are filtered per filter stage at a time. Preferably, ping-pong buffers may be used to buffer phase voltages of binary fractions of a grid frequency period at a time.

For instance, ping-pong buffers may be used to buffer phase voltages and phase currents of a quarter of a grid frequency period in form of a subset of 128 samples while another subset of 128 samples of the latest preceding buffered quarter is processed in the next processing stage. In a first step, a subset of 128 raw samples of the analogue-to-digital converter may be buffered in a first ping-pong buffer. The subset of 128 raw samples spans across a quarter of the nominal grid frequency period. In a second step, the subset of 128 raw samples is resampled by interpolation at the adaptable input sampling rate while another subset of 128 raw samples covering the next quarter of the nominal grid frequency period is buffered in the first ping-pong buffer. The subset of 128 input samples is buffered in a second ping-pong buffer. This means that the resampling is performed every $128/f_s$ second for a subset of 128 raw samples, wherein $f_s$ is the raw sampling rate. If the raw sampling rate $f_s$ given by the analogue-to-digital converter is 56.2432kHz, for instance, the resampling is performed for each subset of 128 raw samples every 2.276 millisecond. In a third step, the subset of 128 buffered input samples is filtered in a first FIR filter while another subset of 128 input samples covering the next quarter of the nominal grid frequency period is buffered in the second ping-pong buffer. The first FIR filter reduces the input sampling rate by one half, so that a subset of 128 filtered input samples covering now two quarters of the nominal grid frequency period can be buffered in a third ping-pong buffer. In a fourth step, the subset of 128 buffered filtered input samples is refiltered in a second FIR filter while another subset of 128 filtered input samples covering the next two quarters of the nominal grid frequency period are buffered in the third ping-pong buffer. The second FIR filter reduces the input sampling rate again by one half, so that the subset of 128 refiltered input samples covering four quarters of the nominal grid frequency period can be buffered in a fourth ping-pong buffer. This means that the fourth ping-pong buffer contains a subset of 128 refiltered input samples covering exactly one full period of the grid frequency. In a fifth step, this subset of 128 buffered refiltered input samples may be fed into an FFT to calculate the phase shift.

Optionally, the grid frequency estimation algorithm may be configured to provide a time stamp for each period of the grid frequency to other applications for being executed by the at least one microcontroller. The time stamp may be provided by a clock in form of a real time clock (RTC) and/or a GPS module and passed on through the buffering process.

Optionally, the grid frequency estimation algorithm may be configured to apply a complex transformation of the input samples before determining the phase shift. It is particularly beneficial to apply a complex transformation to symmetrical components in order to provide a grid frequency estimation irrespective of which phase(s) is/are connected to the electricity meter. A complex transformation may thus allow to consider a combination of all phases of the grid for determining the grid frequency rather than considering only one or more phases individually.

According to another aspect of the present invention, a method is provided for estimating a grid frequency by an electricity consumption meter in an electrical grid, wherein the method comprises:

- providing, by means of an analogue-to-digital converter of the electricity consumption meter, raw samples of a voltage and/or a current at a phase of the electrical grid, wherein the voltage and/or the current has a potentially varying grid frequency,
- calculating, by at least one microcontroller of the electricity consumption meter, an electricity consumption from the electrical grid, and
- estimating a grid frequency by executing a grid frequency estimation algorithm on said at least one microcontroller of the electricity consumption meter,

characterised in that
the grid frequency estimation algorithm provides input samples based on the raw samples at an adaptable input sampling rate, wherein the input sampling rate is a whole-numbered multiple of an inversed period length of a preceding period of the grid frequency and adapted by using a feedback signal being fed back in a closed-loop control, wherein the grid frequency is estimated based on a phase shift indicated by the input samples within the period length of said preceding period of the grid frequency.

Optionally, the grid frequency estimation algorithm may adapt the input sampling rate by interpolating between the raw samples and/or by adapting a raw sampling rate at which the analogue-to-digital converter provides the raw samples.

Optionally, the input samples may be provided within one period of the grid frequency.

Optionally, the input sampling rate may be a radix-2 multiple of the inversed period length of said preceding period of the grid frequency.

Optionally, the grid frequency may be continuously or periodically re-estimated each whole-numbered and/or half-numbered multiple of the period of the grid frequency based on the input samples, wherein the re-estimated grid frequency is provided to other applications for being executed by the at least one microcontroller and is used to provide the feedback signal for the following grid frequency estimation for a subsequent period of the grid frequency.

Optionally, one or more filter stages may be applied for reducing noise from the input samples before the grid frequency is estimated on a filtered subset of input samples that spans exactly across the period length of said preceding period of the grid frequency.

Optionally, a Fast-Fourier-Transformation on the input samples may be applied for determining the phase shift.

Optionally, the input sampling rate may be increased if the phase shift is positive and decreased if the phase shift is negative.

Optionally, the feedback signal may be determined based on the phase shift and an adjusted period length, wherein the period length is adjusted based on a known group delay induced by any one or more filter stages applied before the grid frequency is estimated.

Optionally, each period of the grid frequency may be interpolated in binary fractions of a period at a time, wherein the input samples are consecutively buffered in corresponding binary fractions, wherein one or more filter stages are applied for reducing noise from the buffered input samples, wherein each of the one or more filter stages reduces the input sampling rate by half and doubles the number of buffered binary fractions of the input samples that are filtered per filter stage at a time.

Optionally, a time stamp may be provided for each period of the grid frequency to other applications for being executed by the at least one microcontroller.

Optionally, a complex transformation of the input samples may be applied before determining the phase shift. A complex transformation, e. g. to symmetrical components, may thus allow to consider a combination of all phases of the grid for determining the grid frequency rather than considering only one or more phases individually.

According to another aspect of the present invention, a computer program is provided comprising instructions which, when the program is executed by a computer, cause the computer to carry out the previously described method.

Optionally, the computer program may be executable by an electricity meter for determining electricity consumption in an electrical grid.

SUMMARY OF THE DRAWINGS

Embodiments of the present invention will now be described by way of example with reference to the following figures of which:

Fig. 1    shows schematically an example of an electricity grid with electricity meters according to the present invention; and

Fig. 2    shows schematically an example a frequency estimation algorithm according to the present invention.

DETAILED DESCRIPTION

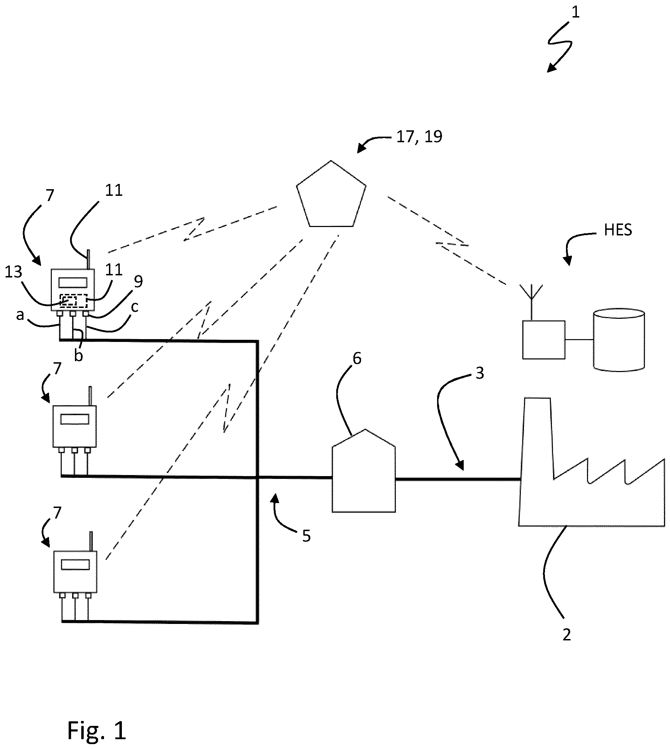

Fig. 1 shows an electrical grid 1 in form of a three-phase electrical grid 1 in a very simplified and schematic way. It should be noted that the invention is applicable for electrical grids with only one phase or any number of phases. A three-phase electrical grid is just shown as an example. A power plant 2 or any other electrical energy source feeds electric energy into the electrical grid 1 in form of a supply AC voltage on three phase lines a, b, c. The electrical grid 1 comprises a transmission network level 3 and a distribution network level 5. The transmission network level 3 may be operated at high transmission voltages above 60kV for efficiently transporting the electric energy from the power plant 2 over long distances, whereas the distribution network level 5 may be operated at voltages below 60kV to connect consumer sites (not shown) to the electrical grid 1. A typical consumer site, e.g. household, is connected to the distribution network level 5 at a supply voltage below 10 kV; the majority of the consumer sites is in fact connected at a supply voltage below 1 kV. The transmission network level 3 and the distribution network level 5 are separated by at least one transformer station 6 transforming the high transmission voltage down to the supply voltage. There may be more than one transmission network level 3 with additional transformer stations between them, so that the voltage may be reduced in steps across the different network levels. Fig. 1 shows the transformer station 6 at the lowest network level, i.e. the transformer station 6 at the distribution network level 5, i.e. being closest to the consumer site and providing the supply voltage to the consumer site.

The transformer station 6 provides an electro-motoric force (EMF) or supply AC voltage via the respective phase lines a, b, c of the electrical grid 1 at the distribution network level 5. An electricity meter 7 is installed at each consumer site, wherein the electricity meter 7 is predominantly used to determine the power consumption of said consumer site. The electricity meter 7 comprises connection terminals 9 connected to each of the phase lines a, b, c of the electrical grid 1. The electricity meter 7 comprises a circuit 11 for determining a voltage $V_a$, $V_b$, $V_c$ and/or a current $I_a$, $I_b$, $I_c$ at the respective phase a, b, c of the electrical grid 1. One or more of the phase voltages $V_a$, $V_b$, $V_c$ may be determined relative to a neutral wire N at ground potential. The neutral wire N takes the sum of the phase currents $I_a$, $I_b$, $I_c$, which is zero in a perfectly balanced situation and non-zero in a non-balanced situation. In case there is no neutral wire or for other reasons, any phase may be chosen to serve as a reference potential in relation to which the phase voltages $V_a$, $V_b$, $V_c$ are defined.

The electricity meter 7 comprises at least one microcontroller 13 for calculating electricity consumption from the electrical grid 1. The microcontroller 13 may comprise the circuit 11 for determining any one of the voltages $V_a$, $V_b$, $V_c$ and/or the currents $I_a$, $I_b$, $I_c$. Alternatively, or in addition, the microcontroller 13 may be part of the circuit 11 or the microcontroller 13 and the circuit 11 may be separate electronic components of the electricity meter 7. Calculating electricity consumption is the primary capability of the electricity meter 7 in order to provide information about the electricity consumption for billing purposes. The electricity meter 7 may comprise a communication interface 11 for connecting preferably wirelessly, or via cable, to a communication network 17 and/or to an automatic metering infrastructure (AMI) 19 in order to provide regularly, sporadically or continuously electricity consumption data to a head-end-system HES of a utility company. The head-end-system HES receives and collects electricity consumption data from a plurality of electricity meters 7 being installed at a plurality of distributed consumer sites.

In addition to the primary capability of calculating and providing electricity consumption data, the electricity meter 7 has a secondary capability to estimate the grid frequency. A utility provider has a high interest in knowing the grid frequency as quickly and as precisely as possible. Therefore, the electricity meter 7 comprises a grid frequency estimation algorithm, preferably in form of software, for being executed by the microcontroller 13.

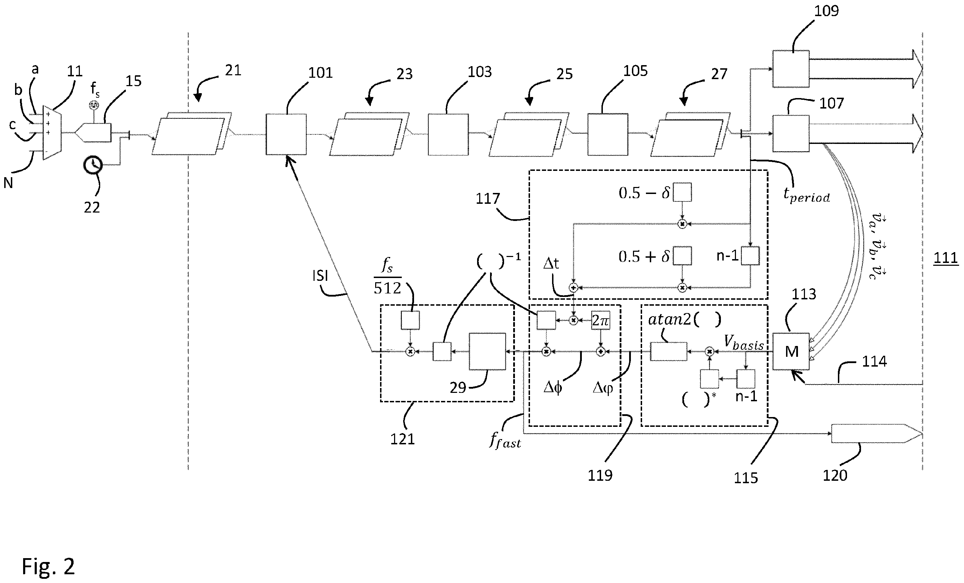

Fig. 2 shows schematically an example of an implementation of the grid frequency estimation algorithm. The electricity meter 7 comprises a digital-to analogue converter 15 which receives from the circuit 11 an analogue voltage and/or current at the three phases a, b, c of the grid. The received analogue voltage and/or the current of the grid has a potentially varying grid frequency. The digital-to-analogue converter (ADC) 15 has in this example a fixed raw sampling rate $f_s$ of 56.2432 kHz. The digital-to-analogue converter (ADC) 15 has in this case multiple channels to sample the three phases in parallel. However, the frequency estimation could also work on the basis of sampling only a single phase or any number of the phases.

A Direct Memory Access (DMA) controller (not shown) controls a buffering of the digital raw samples provided by the ADC 15 into a working memory of the microcontroller 13. A first buffer 21 of the working memory of the microcontroller 13 contains here a subset of 128 raw samples for each phase in a ping-pong buffer structure, wherein the subset of 128 raw samples is filled while a previously buffered subset of 128 samples is processed in parallel. A clock 22 in form of a real time clock (RTC) and/or a GPS module provides here a time stamp for each buffered subset of 128 raw samples.

Once the raw samples are buffered into the working memory of the microcontroller 13, the grid frequency estimation algorithm is implemented by software in form of firmware that is executable by the microcontroller 13. As the hardware components, i. e. the circuit 11, the ADC 15, the RTC/GPS 22, the DMA controller and the microcontroller 13 are usually readily available in existing electricity meters 7, the inventive grid frequency estimation algorithm can be implemented on existing hardware by a firmware update. Preferably, such a firmware update may be uploaded via the communication network 17 and/or via the automatic metering infrastructure (AMI) 19 to already installed electricity meters 7.

Before the sampled data can be transformed into the frequency domain, e. g. by a Fast-Fourier-Transformation (FFT), for estimating the grid frequency, three pre-processing steps 101, 103, 105 are performed in the time-domain to avoid spectral leakage and to reduce noise. In order to avoid spectral leakage in the frequency domain, the subset of samples to be transformed into the frequency domain must exactly fit into one fundamental period length of the grid frequency. In case of using FFT, the subset size of samples is preferably a radix-2 multiple, e. g. 128 in this case. Typically, the ADC 15 has a fixed raw sampling rate $f_s$, in this case 56.2432 kHz. If the raw sampling rate of the ADC 15 is adaptable, one solution to provide the required time span of the subset of samples is to adapt the raw sampling rate of the ADC 15 according to the current grid frequency. If the raw sampling rate of the ADC 15 is fix, as in the example shown in Fig. 2, however, an interpolation 101 may be used to provide the required time span of the subset.

So, in a first pre-processing step 101, the buffered subset of 128 raw samples is resampled by interpolating between the subset of 128 raw samples. Apart from the buffered subset of 128 raw samples, the interpolation step 101 receives a feedback signal ISI via a closed-loop as input. The feedback signal ISI contains information about the current grid frequency that has been estimated earlier based on a preceding period of the grid frequency. In the present case, the feedback signal ISI is an input sample interval (ISI)

$$\text{ISI} = \frac{f_s}{f_{res}},$$

wherein $f_{res}$ is the input sampling rate and $f_s$ is the raw sampling rate. In case of 50.00Hz grid frequency, ISI is 2.197 raw samples per input sample. ISI expresses the distance in number of raw samples between two consecutive input sample points.

The interpolated output of the interpolation step 101 is here a weighted sum of two consecutive raw samples: $s_{out}[k] = q_0[k] \cdot s_{in}[n + 1] + (1 - q_0[k]) \cdot s_{in}[n]$, where the weight $q_0[k] \in [0{:}1]$ is the fractional part of an input sample point (ISP), wherein $s_{out}[k]$ is calculated with

$$\text{ISP}[k] = \text{ISP}[k-1] + \text{ISI}$$

$$n = \text{floor}(\text{ISP}[k])$$

$$q_o[k] = \text{ISP}[k] - n$$

If the scale is ignored until a later process, this can be written as

$$s_{in}[n] = s_{raw}[n] + s_{raw}[n-1].$$

Substituting this into the expression for $s_{out}$ and time shift $n$ to make the process causal, gives:

$$s_{out}[k] = q_0[k] \cdot (s_{raw}[n] + s_{raw}[n-1]) + (1 - q_0[k])$$
$$\cdot (s_{raw}[n-1] + s_{raw}[n-2])$$
$$= q_0[k] \cdot s_{raw}[n] + q_0[k] \cdot s_{raw}[n-1] + (1 - q_0[k]) \cdot s_{raw}[n-1]$$
$$+ (1 - q_0[k]) \cdot s_{raw}[n-2]$$
$$\Updownarrow$$
$$s_{out}[k] = q_0[k] \cdot s_{raw}[n] + s_{raw}[n-1] + (1 - q_0[k]) \cdot s_{raw}[n-2]$$

The data $s_{out}$ from this interpolation step 101 is buffered in a subset of 128 input samples at a time in a second ping-pong buffer 23 of the working memory of the microcontroller 13, wherein one part of the second ping-pong buffer 23 is filled by this interpolation step 101 while the other part is being processed by a subsequent pre-processing step 103.

The time span for the subset of the 128 input samples of $s_{out}$ is

$$128 \cdot \frac{DSI}{f_s} = \frac{128 \cdot DSI}{56.2432\,\text{kHz}} \ .$$

After the interpolation, the 128 input samples span across exactly one quarter of the current grid frequency as it has been estimated on the basis of a preceding period. During nominal conditions of 50.00Hz grid frequency, the time span of one full buffer of a subset of 128 input samples is then exactly 5.00$ms$ or 281.216 raw samples. If the grid frequency changes, the ISI is adapted to adapt the input sampling rate. The time span of the 128 input samples buffered in the second ping-pong buffer 23, which depends on the ISI, is forwarded to the subsequent pre-processing step 103 to keep track of the period length. Also, the time stamp associated with the subset of the 128 input samples buffered in the second ping-pong buffer 23 is passed on to the subsequent pre-processing step 103.

The subsequent pre-processing 103 is a first filtering step for reducing noise. The first filtering step 103 is applied to decimate the subset of 128 input samples buffered in the second ping-pong buffer 23 by one half. The first filtering step 103 can thus be considered as a down sampling low pass filter, which is implemented as a first FIR filter. A third ping-pong buffer 25 of the working memory of the microcontroller 13 can thus be filled with two subsets of each 64 filtered input samples. The total subset of the 128 filtered input samples buffered in the third ping-pong buffer 25 spans across one half of the period length of the grid frequency. The time span of the 128 input samples buffered in the third ping-pong buffer 25 is forwarded to the subsequent pre-processing step 105 to keep track of the period length. Also, the time stamp associated with the buffered subset of the 128 filtered input samples is passed on to the subsequent pre-processing step 105.

The subsequent pre-processing 105 is a second filtering step for further reducing noise. As the data rate has been reduced by one half in the preceding first filtering step 103, the second filtering step 105 has twice the available processing time, so that the filter complexity can be higher for the second filtering step 105 compared to the first filtering step 103. The second filtering step 105 is applied to decimate the subset of 128 filtered input samples buffered in the third ping-pong buffer 25 again by one half. The second filtering step 105 can thus be considered as a down sampling low pass filter, which is implemented as a second FIR filter. A fourth ping-pong buffer 27 of the working memory of the microcontroller 13 can thus be filled with two subsets of each 64 refiltered input samples. The total subset of the 128 refiltered input samples buffered in the fourth ping-pong buffer 27 spans across one full period length of the grid frequency. The time span $\Delta t$ of the 128 refiltered input samples buffered in the fourth ping-pong buffer 27 is forwarded to the subsequent process to keep track of the period length. Also, the time stamp associated with the buffered subset of the 128 refiltered input samples is passed on to the subsequent process.

After the three pre-processing steps 101, 102, 103, a Fast-Fourier-Transformation (FFT) is performed in transformation step 107 for each phase a, b, c of the grid on the basis of the respective 128 refiltered input samples that are buffered in the fourth ping-pong buffer 27 for each phase and that span exactly across one precedent period length. Furthermore, the time stamp is passed on in step 109 for further use in other smart meter applications 111 executed by the microcontroller 13 at a higher level.

The output of the FFT in transformation step 107 is a DC component plus 63 complex harmonic frequency components for each phase a, b, c, which is also passed on for further use in other smart meter applications 111 executed by the microcontroller 13 at a higher level. For the grid frequency estimation algorithm, however, only the fundamental components $\overline{v}_a$, $\overline{v}_b$ and $\overline{v}_c$, i.e. the second and complex bins of the FFT for each phase, are of interest. They describe the amplitude and phase angle of the fundamental components for each phase a, b, c.

It is possible to use only one of the phases a, b, c for the grid frequency estimation algorithm. However, if the frequencies in all three phases a, b, c are to be taken into account, it is beneficial to make a transformation to symmetrical components. The transformation to symmetrical components is performed by applying a complex size operator $a$, which denotes a 120° phase shift, wherein

$$a = e^{i\frac{2\pi}{3}} = \cos(120°) + i\sin(120°)$$

$$\approx -0.5 + i0.866$$

The operator $a^2$ represents a phase shifts of 240°. Thus,

$$a^2 = e^{i\frac{4\pi}{3}} = \cos(240°) + i\sin(240°)$$

$$\approx -0.5 - i0.866$$

The transformation matrix

$$T = \begin{bmatrix} 1 & 1 & 1 \\ 1 & a^2 & a \\ 1 & a & a^2 \end{bmatrix}$$

$$\Updownarrow$$

$$T^{-1} = \frac{1}{3}\begin{bmatrix} 1 & 1 & 1 \\ 1 & a & a^2 \\ 1 & a^2 & a \end{bmatrix}$$

determines the relationship between normal components $V_{abc}$ and symmetrical components $V_{012}$ as

$$V_{abc} = TV_{012}$$

and

$$V_{012} = T^{-1}V_{abc}$$

It depends on the connection and configuration of the terminals 9 of the electricity meter 7 to the phases a, b, c of the grid 1 how the normal components are to be transformed to the symmetrical components in transformation step 113 by means of a selectable transformation matrix M. The following table gives an overview of the different selectable and/or configurable connections and configurations:

| Connection and Configuration | Transform by $V_{basis=}\boldsymbol{M} \cdot [\vec{v}_a \quad \vec{v}_b \quad \vec{v}_c]^T$ |
|---|---|
| Phase a, b, and c connected to meter's terminal a, b, and c in positive sequence. | $M = [1\ a\ a^2]$ |
| Phase a, b, and c connected to meter's terminal a, b, and c in negative sequence. | $M = [1\ a^2\ a]$ |
| Only terminal a on the meter is connected, with the two others left open or shorted to a or the neutral terminal. | $M = [1\ 0\ 0]$ |
| Only terminal b on the meter is connected, optionally with terminal c shorted to b or the neutral terminal. | $M = [0\ 1\ 0]$ |
| Only terminal c on the meter is connected. | $M = [0\ 0\ 1]$ |
| Phase a and b connected to meter's terminal a and b in positive sequence with c left open or shorted to either a, b, or the neutral terminal. | $M = [1\ a\ 0]$ |
| Phase a and b connected to meter's terminal a and b in negative sequence with c left open or shorted to either a, b, or the neutral terminal. | $M = [1\ a^2\ 0]$ |

(continued)

| Connection and Configuration | Transform by $V_{basis=}M \cdot [\vec{v}_a \quad \vec{v}_b \quad \vec{v}_c]^T$ |
|---|---|
| Phase a and c connected to meter's terminal a and c in positive sequence with b left open or shorted to either a, or the neutral terminal. | $M = [1\ 0\ a^2]$ |
| Phase a and c connected to meter's terminal a and c in negative sequence with b left open or shorted to either a, or the neutral terminal. | $M = [1\ 0\ a]$ |
| Phase b and c connected to meter's terminal b and c in positive sequence with a left open or shorted to the neutral terminal. | $M = [0\ a\ a^2]$ |
| Phase b and c connected to meter's terminal b and c in negative sequence with a left open or shorted to the neutral terminal. | $M = [0\ a^2\ a]$ |

One of the smart meter applications 111 may provide a user interface and/or an automatic selector for configuring 114 the grid frequency estimation algorithm by selecting the appropriate transformation matrix M. However, the performance of the inventive grid frequency estimation algorithm is essentially independent of the connections and configuration as along as the correct configuration is selected. Using the transformation matrix M instead of the complete transformation matrix T means that the negative-sequence components and zero-sequence components are ignored in this example. Only the positive-sequence components are here used to estimate the grid frequency .

The output of the transformation step 113 is a symmetrical representation $V_{basis}$ of the three complex fundamental frequency components $\bar{v}_a$, $\bar{v}_b$ and $\bar{v}_c$. The scale can be ignored here, because only the phase angle $\Delta\varphi$ is of interest for the grid frequency estimation algorithm, which is calculated in calculation 115 as

$$\Delta\varphi[n] = \arg\bigl(V_{basis}[n] \cdot \mathrm{conj}(V_{basis}[n-1])\bigr)$$
$$= atan2\bigl(Im\bigl(V_{basis}[n] \cdot \mathrm{conj}(V_{basis}[n-1])\bigr), Re\bigl(V_{basis}[n] \cdot \mathrm{conj}(V_{basis}[n-1])\bigr)\bigr)$$

The grid frequency $f_{fast}$ is estimated based on the phase shift $\Delta\varphi$ by $f_{fast} = \frac{2\pi + \Delta\varphi}{\Delta t \cdot 2\pi}$ , wherein $\Delta t$ is calculated in calculation 117 based on the time span $\Delta t$ buffered in the fourth ping-pong buffer 27 by

$$\Delta t[n] = (0.5 - \delta) \cdot t_{period}[n] + (0.5 + \delta) \cdot t_{period}[n-1] ,$$

wherein $t_{period}[n]$ is the time length of the n-th grid frequency period and $\delta$ is a known group delay induced by the two filter steps 103, 105. The group delay is $\delta_1 = \frac{M_1}{2 \cdot 512}$ for the first filter and $\delta_2 = \frac{M_2}{2 \cdot 256}$ for the second filter, and the total group delay induced by the two filter steps 103, 105 is thus $\delta = \delta_1 + \delta_2$. $M_1$ is the known number of filter bins of the first filter 103 and $M_2$ is the known number of filter bins of the second filter 105.

Then, calculation 119 results in the grid frequency $f_{fast}$ being estimated as $f_{fast} = \frac{2\pi + \Delta\varphi}{\Delta t \cdot 2\pi}$ , which is provided in step 120 to be used in the smart meter applications 111. For example, the smart meter applications 111 may communicate the grid frequency $f_{fast}$ via the communication network 17 and/or via the automatic metering infrastructure (AMI) 19 to the HES.

The estimated grid frequency $f_{fast}$ is further used to derive the feedback signal ISI to be provided in a closed loop for the subsequent grid frequency estimation. The ISI is updated in calculation 121 using the formula:

$$ISI = \frac{f_s}{N \cdot f_{fast}} ,$$

wherein $N = 128 \cdot 2 \cdot 2 = 512$ and $f_s$ is the fixed raw sampling rate given by the analogue-to-digital converter. The feedback signal ISI is used for the interpolation step 101 in the subsequent grid frequency estimation. In order to reduce the worst high-frequency noise from the estimated grid frequency $f_{fast}$, an optional simple FIR filter 29 with even weighted coefficients is used here before the ISI is updated within the closed-loop.

The smart meter applications 111 making use of the estimated grid frequency could be, for example, frequency-dependent activations of relays, calculation of individual harmonic components in the current and voltage waveforms, calculation of rate of change of frequency (ROCOF) for stability monitoring, frequency-dependent tariffs and billing, validation of delivered ancillary services like frequency containment reserve (FCR) and fast frequency response (FFR), etc.

Where, in the foregoing description, integers or elements are mentioned which have known, obvious or foreseeable equivalents, then such equivalents are herein incorporated as if individually set forth. Reference should be made to the claims for determining the true scope of the present disclosure, which should be construed so as to encompass any such equivalents. It will also be appreciated by the reader that integers or features of the disclosure that are described as optional, preferable, advantageous, convenient or the like are optional and do not limit the scope of the independent claims.

The above embodiments are to be understood as illustrative examples of the disclosure. It is to be understood that any feature described in relation to any one embodiment may be used alone, or in combination with other features described, and may also be used in combination with one or more features of any other of the embodiments, or any combination of any other of the embodiments. While at least one exemplary embodiment has been shown and described, it should be understood that other modifications, substitutions and alternatives are apparent to one of ordinary skill in the art and may be changed without departing from the scope of the subject matter described herein, and this application is intended to cover any adaptations or variations of the specific embodiments discussed herein.

In addition, "comprising" does not exclude other elements or steps, and "a" or "one" does not exclude a plural number. Furthermore, characteristics or steps which have been described with reference to one of the above exemplary embodiments may also be used in combination with other characteristics or steps of other exemplary embodiments described above. Method steps may be applied in any order or in parallel or may constitute a part or a more detailed version of another method step. It should be understood that there should be embodied within the scope of the patent warranted hereon all such modifications as reasonably and properly come within the scope of the contribution to the art. Such modifications, substitutions and alternatives can be made without departing from the spirit and scope of the disclosure, which should be determined from the appended claims and their legal equivalents.

List of reference numerals:

| 1 | electricity grid |
| 2 | power plant |
| 3 | transmission network level |
| 5 | distribution network level |
| 7 | electricity meter |
| 9 | terminals |
| 11 | circuit |
| 13 | microcontroller |
| 15 | analogue-to-digital converter (ADC) |
| 17 | communication network |
| 19 | automatic metering infrastructure (AMI) |
| HES | head-end system |
| 21 | first ping-pong buffer |
| 22 | clock RTC/ GPS |
| 25 | second ping-pong buffer |
| 25 | third ping-pong buffer |
| 27 | fourth ping-pong buffer |
| 29 | FIR filter |
| 101 | interpolation step |
| 103 | first filtering step |
| 105 | second filtering step |
| 107 | applying FFT |
| 109 | transmitting time stamp |
| 111 | smart meter application(s) |
| 113 | transformation step |
| 114 | configuring |
| 115 | calculation |

| 117 | calculation |
| 119 | calculation |
| 120 | providing the estimated frequency |
| 121 | calculation |
| ISI | input sample interval / feedback signal |

**Claims**

1. An electricity meter (7) for determining electricity consumption in an electrical grid (1), wherein the electricity meter (7) comprises:

   - an analogue-to-digital converter (15) for providing raw samples of a voltage and/or a current at a phase (a, b, c) of the electrical grid (1), wherein the voltage and/or the current has a potentially varying grid frequency,
   - at least one microcontroller (13) for calculating electricity consumption from the electrical grid (1), and
   - a grid frequency estimation algorithm for being executed by the at least one microcontroller (13),

   **characterised in that**
   the grid frequency estimation algorithm is configured to provide input samples based on the raw samples at an adaptable input sampling rate, wherein the input sampling rate is a whole-numbered multiple of an inversed period length of a preceding period of the grid frequency and adapted by using a feedback signal (ISI) being fed back in a closed-loop control, wherein the grid frequency estimation algorithm is configured to estimate the grid frequency based on a phase shift ($\Delta\varphi$) indicated by the input samples within the period length of said preceding period of the grid frequency.

2. The electricity meter (7) according to claim 1, wherein the grid frequency estimation algorithm is configured to adapt the input sampling rate by interpolating (101) between the raw samples and/or by adapting a raw sampling rate ($f_s$) at which the analogue-to-digital converter (15) provides the raw samples.

3. The electricity meter (7) according to claim 1 or 2, wherein the grid frequency estimation algorithm is configured to provide the input samples within one period of the grid frequency.

4. The electricity meter (7) according to any of the preceding claims, wherein the grid frequency estimation algorithm is configured to continuously or periodically re-estimate the grid frequency each whole-numbered and/or half-numbered multiple of the period of the grid frequency based on the input samples, wherein the re-estimated grid frequency is provided to other applications (111) for being executed by the at least one microcontroller (13) and is used to provide the feedback signal (ISI) for the following grid frequency estimation for a subsequent period of the grid frequency.

5. The electricity meter (7) according to any of the preceding claims, wherein the grid frequency estimation algorithm is configured to apply one or more filter stages (103, 105) for reducing noise from the input samples before the grid frequency is estimated on a filtered subset of input samples that spans exactly across the period length of said preceding period of the grid frequency.

6. The electricity meter (7) according to any of the preceding claims, wherein the grid frequency estimation algorithm is configured to increase the input sampling rate if the phase shift ($\Delta\varphi$) is positive and to decrease the input sampling rate if the phase shift ($\Delta\varphi$) is negative.

7. The electricity meter (7) according to any of the preceding claims, wherein the grid frequency estimation algorithm is configured to determine the feedback signal (ISI) based on the phase shift ($\Delta\varphi$) and an adjusted period length ($\Delta t$), wherein the period length is adjusted based on a known group delay ($\delta$) induced by any one or more filter stages (103, 105) applied before the grid frequency is estimated.

8. The electricity meter (7) according to any of the preceding claims, wherein the grid frequency estimation algorithm is configured to interpolate (101) one period of the grid frequency in binary fractions of a period at a time and to consecutively buffer the input samples in corresponding binary fractions, wherein the grid frequency estimation algorithm is further configured to apply one or more filter stages (103, 105) for reducing noise from the buffered binary fractions of the input samples, wherein each of the one or more filter stages (103, 105) reduces the input sampling rate by half and doubles the number of buffered binary fractions of the input samples that are filtered per filter stage (103, 105) at a time.

9.  The electricity meter (7) according to any of the preceding claims, wherein the grid frequency estimation algorithm is configured to provide a time stamp for each period of the grid frequency to other applications (111) for being executed by the at least one microcontroller (13).

10. The electricity meter (7) according to any of the preceding claims, wherein the grid frequency estimation algorithm is configured to apply a complex transformation (113) of the input samples before determining the phase shift ($\Delta\varphi$).

11. A method for estimating a grid frequency by an electricity consumption meter (7) in an electrical grid (1), wherein the method comprises:

    - providing, by means of an analogue-to-digital converter (15) of the electricity consumption meter (7), raw samples of a voltage and/or a current at a phase (a, b, c) of the electrical grid (1), wherein the voltage and/or the current has a potentially varying grid frequency,
    - calculating, by at least one microcontroller (13) of the electricity consumption meter (7), an electricity consumption from the electrical grid (1), and
    - estimating a grid frequency by executing a grid frequency estimation algorithm on said at least one microcontroller (13) of the electricity consumption meter (7),

    **characterised in that**
    the grid frequency estimation algorithm provides input samples based on the raw samples at an adaptable input sampling rate, wherein the input sampling rate is a whole-numbered multiple of an inversed period length of a preceding period of the grid frequency and adapted by using a feedback signal (ISI) being fed back in a closed-loop control, wherein the grid frequency is estimated based on a phase shift ($\Delta\varphi$) indicated by the input samples within the period length of said preceding period of the grid frequency.

12. The method according to claim 11, wherein the grid frequency estimation algorithm adapts the input sampling rate by interpolating (101) between the raw samples and/or by adapting a raw sampling rate at which the analogue-to-digital converter (15) provides the raw samples.

13. The method according to claim 11 or 12, the input samples are provided within one period of the grid frequency.

14. The method according to any of the claims 11 to 13, wherein the grid frequency is continuously or periodically re-estimated each whole-numbered and/or half-numbered multiple of the period of the grid frequency based on the input samples, wherein the re-estimated grid frequency is provided to other applications (111) for being executed by the at least one microcontroller (13) and is used to provide the feedback signal (ISI) for the following grid frequency estimation for a subsequent period of the grid frequency.

15. The method according to any of the claims 11 to 14, wherein one or more filter stages (103, 105) are applied for reducing noise from the input samples before the grid frequency is estimated on a filtered subset of input samples that spans exactly across the period length of said preceding period of the grid frequency.

16. The method according to any of the claims 11 to 15, wherein the input sampling rate is increased if the phase shift ($\Delta\varphi$) is positive and decreased if the phase shift ($\Delta\varphi$) is negative.

17. The method according to any of the claims 11 to 16, wherein the feedback signal (ISI) is determined based on the phase shift ($\Delta\varphi$) and an adjusted period length ($\Delta t$), wherein the period length ($\Delta t$) is adjusted based on a known group delay induced by any one or more filter stages (103, 105) applied before the grid frequency is estimated.

18. The method according to any of the claims 11 to 17, wherein each period of the grid frequency is interpolated (101) in binary fractions of a period at a time, wherein the input samples are consecutively buffered in corresponding binary fractions, wherein one or more filter stages (103, 105) are applied for reducing noise from the buffered input samples, wherein each of the one or more filter stages (103, 105) reduces the input sampling rate by half and doubles the number of buffered binary fractions of the input samples that are filtered per filter stage at a time.

19. The method according to any of the claims 11 to 18, wherein a time stamp is provided for each period of the grid frequency to other applications (111) for being executed by the at least one microcontroller (13).

20. The method according to any of the claims 11 to 19, wherein a complex transformation (113) of the input samples is applied before determining the phase shift ($\Delta\varphi$).

Fig. 1

Fig. 2

Europäisches
Patentamt

European
Patent Office

Office européen
des brevets

## EUROPEAN SEARCH REPORT

**Application Number**

EP 23 21 2946

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2018/059154 A1 (MECREANT JULIEN [FR] ET AL) 1 March 2018 (2018-03-01)<br>* abstract; figures 2-5b *<br>* paragraphs [0002] - [0028], [0070] - [0088] *<br>* paragraph [0108] * | 1-6,9, 11-15,19<br>7,8,10, 17,18,20 | INV.<br>G01R21/133<br>G01R22/10<br>G01R23/02 |
| A,D | ----- <br>US 2023/143318 A1 (BOBICK DAVID A [US]) 11 May 2023 (2023-05-11)<br>* the whole document *<br>----- | 1-18 | |

**TECHNICAL FIELDS SEARCHED (IPC)**

G01R

The present search report has been drawn up for all claims

| Place of search | Date of completion of the search | Examiner |
|---|---|---|
| Munich | 21 May 2024 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2946

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2024

| Patent document cited in search report | Publication date | Patent family member(s) | | Publication date |
|---|---|---|---|---|
| US 2018059154 A1 | 01-03-2018 | CN | 107782966 A | 09-03-2018 |
| | | EP | 3287795 A1 | 28-02-2018 |
| | | FR | 3055417 A1 | 02-03-2018 |
| | | US | 2018059154 A1 | 01-03-2018 |
| US 2023143318 A1 | 11-05-2023 | AU | 2022387407 A1 | 04-04-2024 |
| | | CA | 3232848 A1 | 19-05-2023 |
| | | US | 2023143318 A1 | 11-05-2023 |
| | | WO | 2023086268 A1 | 19-05-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20230143318 A1
- US 7444249 A